Europäisches Patentamt

European Patent Office

Office européen des brevets

(11) Publication number : **0 466 453 A2**

(12) **EUROPEAN PATENT APPLICATION**

(21) Application number : **91306214.7**

(22) Date of filing : **09.07.91**

(51) Int. Cl.⁵ : **G01R 21/00**

(30) Priority : **10.07.90 GB 9015199**

(43) Date of publication of application :
**15.01.92 Bulletin 92/03**

(84) Designated Contracting States :
**DE ES FR GB IT**

(71) Applicant : **POLYMETERS RESPONSE INTERNATIONAL LIMITED**
**PRI House, Moorside Road, Winnall Industrial Estate**
**Winchester, Hampshire SO23 7RX (GB)**

(72) Inventor : **Fielden, John Spensley**
**Metcombe Brake**
**Ottery St Mary Devon, EX11 1SR (GB)**
Inventor : **James, Andrew Lewis**
**35 Parchment Street**
**Winchester Hampshire, SO23 8BA (GB)**
Inventor : **McCabe, Barnaby John**
**37 Roslyn Road**
**Redland Bristol (GB)**

(74) Representative : **Crawford, Andrew Birkby et al**
**A.A. THORNTON & CO. Northumberland House 303-306 High Holborn**
**London WC1V 7LE (GB)**

(54) **Improvements in and relating to electricity meters using current transformers.**

(57)    Electronic electricity meter, comprising means (8) for evaluating the electrical energy consumed by a load, the evaluating means being adapted to evaluate the energy consumption from a signal indicative of voltage supplied to the load and a signal indicative of load current, said load current signal being produced by a current transformer (4). The meter further comprises storing means (9) storing one or more parameters indicative of the variation with primary current of the phase error or ratio error arising in the secondary current of a current transformer of a predetermined configuration, and the evaluating means is further adapted to process the load current signal so as to produce an adjusted value for the load current signal, said processing making use of said stored parameters. The parameters stored by the storing means (9) preferably comprise a plurality of values of phase error and/or ratio error for a respective plurality of primary current values of the current transformer of predetermined configuration, and the evaluating means is adapted to process the load current signal so as to produce an estimate of primary current in the current transformer, to select from the storing means (9) a value of phase error and/or ratio error for one of said plurality of primary current values corresponding to the estimated value of primary current and to adjust the load current signal using the selected value of phase and/or ratio error.

EP 0 466 453 A2

FIG.3

The present invention relates to electricity meters of the type termed static, solid state, or electronic, and more particularly to such meters using current transformers.

Electronic metering of electrical energy requires the independent sensing of both load current and supply voltage, continuous multiplication of these two quantities to produce instantaneous load power and the integration of varying load power with respect to time to derive accumulated energy useage. In general the sensing of supply voltage is simply effected through a potentiometric resistive divider. The sensing of load current is more problematic and can be effected by a variety of well known means.

The load current can most simply be sensed by use of a resisitive "shunt" in the load current path. This does suffer from instability with respect of temperature and is particularly inconvenient when it is required to reference a number of independent circuits to a common point as may be required in designs of polyphase metering equipment. Nevertheless, especially for single phase metering, a shunt circuit with temperature compensation such as that disclosed, for example, in French Patent 2563013 can be an effective means of current sensing.

The current transformer is a particularly effective means of sensing load current. Typically the whole load current passes through the centre of the transformer core, thereby forming one turn, and the detected secondary current is precisely equal to the load current divided by the number of turns in the secondary winding. The secondary current is effectively driven from a constant current generator, and generates a voltage in a load resistor which is then used as a precise measure of load current so forming one of the inputs to the multiplier circuit, the other being supply voltage as already discussed.

Designs of static meter employing internal current transformers are well established and have been described, for example, in GB 2041588, GB 2040051, GB 2083306.

In polyphase supply situations where high load currents are being drawn, typically from 300 to 1000 Amp, it is common practice to utilise exterior current transformers of known precise ratio, connecting secondary currents of typically 1 Amp or 5 Amp maximum value to the meter. These isolated currents can be directly referenced to a common point or be sensed through further current transformers internal to the body of the meter as described in preceeding paragraphs.

In situations where a medium level of current is to be supplied of the order of 80 Amp to 200 Amp maximum, the conductors are of such manageable size that they can be directly wired without difficulty to a terminal block on the meter. Such arrangements are common for domestic and smaller commercial consumers where electricity is metered without recourse to the use of external measuring current transformers. The term whole-current metering sensibly applies to this simple form of electrical connection, whether on single or polyphase supply.

A problem that arises when using current transformers in, or conjunction with, electricity meters is that magnetisation effects (etc.) cause errors in the current transformer measurements of current. These current transformer errors lead to a lowering of the accuracy of the readings given by the associated electricity meter.

Conventionally this problem is avoided by design of the current transformer in such a way as to minimise the current measurement errors, this can be done for example by using a transformer core made of mumetal rather than the more common grain oriented silicon steel (GOSS) core materials, or by using a large number of turns for core material of relatively low magnetisation current and level of core magnetisation. However these solutions are not entirely satisfactory since, for example, it is more expensive to use a mumetal core than a GOSS core and current transformers having the required number of turns (possibly several thousand) are more costly to make.

The present invention provides a way of reducing the effects of current transformer errors by compensating for those errors either in the electricity meter or in an extra module provided between the current transformer and the meter.

By adopting measures according to the present invention an electricity meter may be obtained having an acceptable level of accuracy while using a current transformer having a GOSS core. The same principles can be employed to reliably correct even large errors as may be experienced with cores constructed of ferrite material.

The errors in current transformer measurement of currents may be separated into 2 parts:

a) phase errors: the phase of the current in the secondary of the current transformer is shifted with respect to that in the primary; and

b) ratio errors: the effective dividing ratio of the current transformer is not constant over a range of primary currents.

It has been found that the phase error (P) varies with the magnitude ($I_1$) of the primary current approximately according to the relationship:

$$P = K_1 + K_2 . I_1^{-M} \quad (1)$$

where M, $K_1$ and $K_2$ are constants

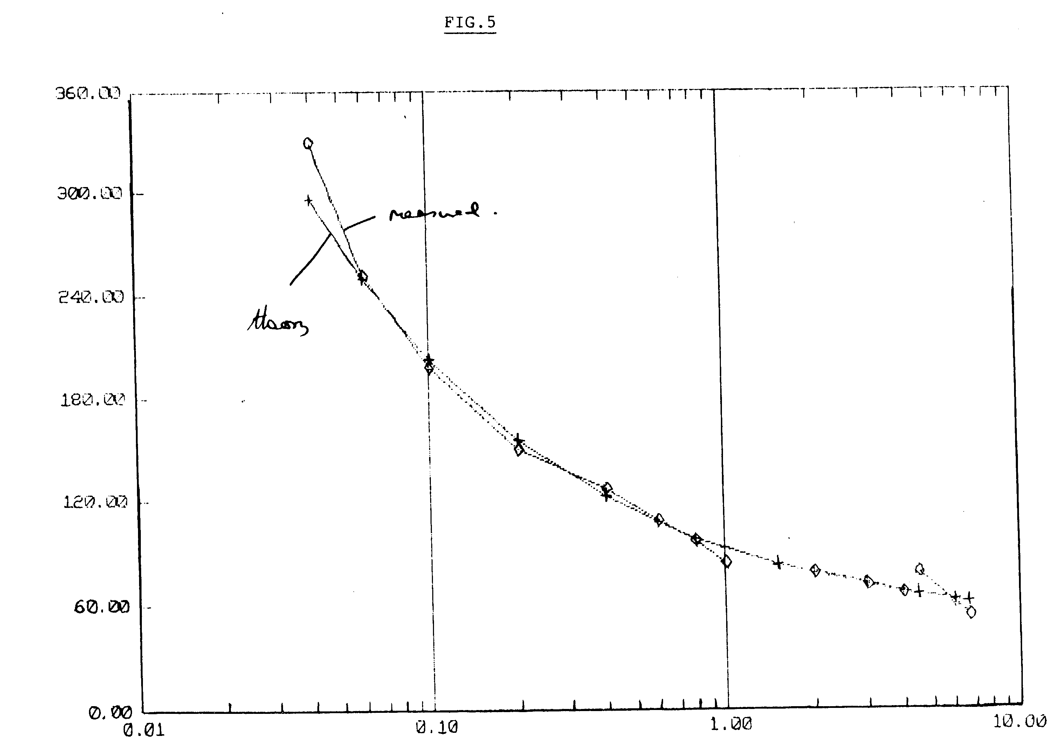

In practice it has been found that the variation of phase error (P) with primary current ($I_1$) often follows equation (1) with M approximately equal to 1/2. Consequently a square root approximation can often conveniently be employed as part of the overall correction algorithm Fig. 5 shows an example of the variation in phase error (P) found for a particular GOSS core, it may be seen that the variation closely fits equation (1) with M = 1/2 within the limits of experimental error. The compensation techniques of the present invention are equally applicable, however, for cores where the value of the power, M, is other than 1/2.

It has also been found that the ratio error ($r_e$) varies with the magnitude ($I_1$) of the primary current as follows:

$$r_e^{(\%)} = K_3 + K_4 \log I_1 \quad (2)$$

where $K_3$ and $K_4$ are constants.

The effect of the ratio error is to alter the relationship between the magnitude of measured secondary current ($I_2$) and primary current ($I_1$) from the theoretical relationship ($I_1 = I_2\, n$), where n = turns ratio, to the actual relationship:

$$I_1 = I_2'(n + \frac{nr_e}{100}) \quad (3)$$

Thus $I_2'$, measured magnitude of secondary current, is related to $I_2$, theoretical magnitude of secondary current, as follows:

$$I_2 = I_2'(1 + {}^{re}/100)$$

The values of the constants $K_1$, $K_2$, $K_3$ and $K_4$ vary dependent upon the configuration of the current transformer, e.g. upon factors such as core material and turns ratio, and may be ascertained by experiment for any given core configuration.

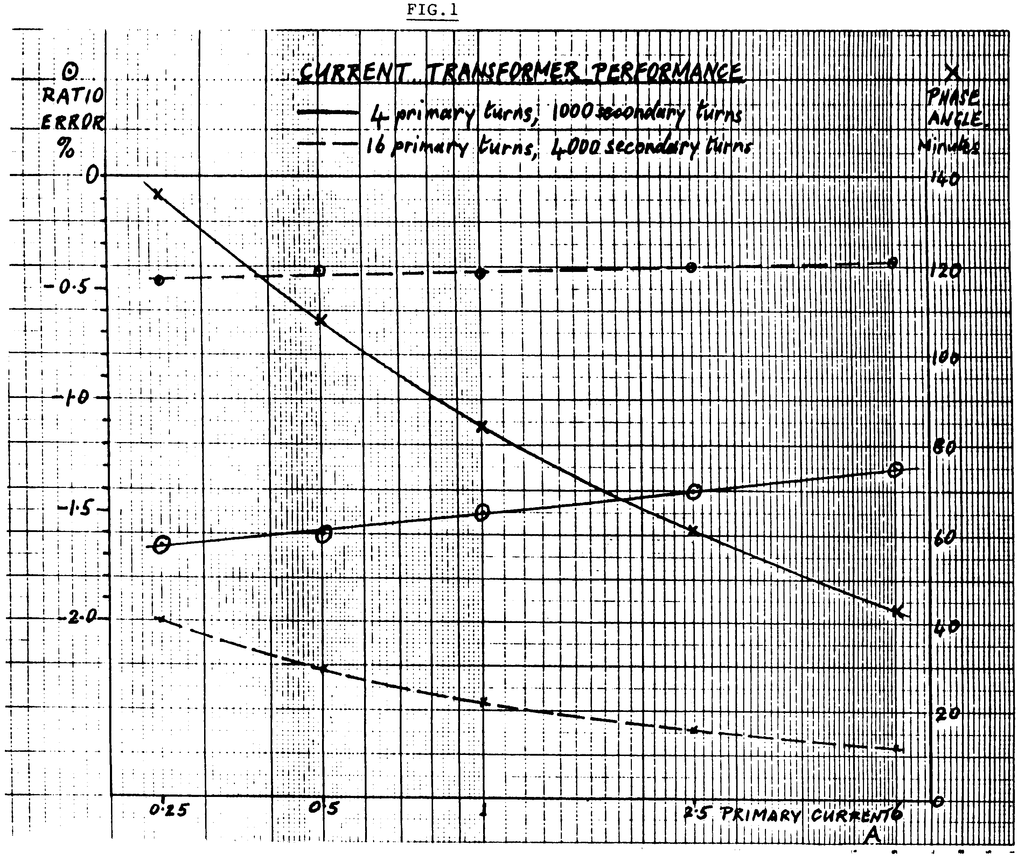

Fig. 1 illustrates the variation of phase error and ratio error with the logarithm of primary current magnitude, at low current values, observed for a current transformer rated at 100A having a burden of 40 ohms and having a GOSS (grain orientated silicon steel) core, in a first configuration (shown in solid lines) having a primary winding having 4 turns and a secondary winding having 1000 turns, and in a second configuration (dashed lines) having 16 and 4000 turns respectively. The values of constants $K_1$, $K_2$, $K_3$ and $K_4$ of equations (1) and (2) above may be derived from graphs such as these.

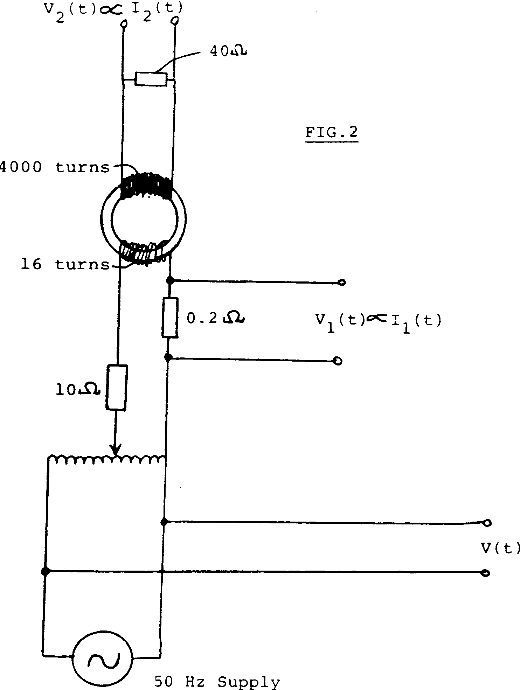

Fig. 2 shows an experimental set-up which may be used to obtain the data for graphs such as those of Fig. 1.

By evaluating and storing the values of $K_1$, $K_2$ $K_3$ and $K_4$ for a given current transformer configuration it becomes possible substantially to compensate for phase error and/or ratio error arising when that CT configuration is used to measure a current. Thus a CT unit can be made incorporating correction circuitry.

In metering situations, the phase errors and/or ratio errors arising in a current transformer which is internal to an electronic electricity meter may be compensated, for example in the data processing section of the meter. If that meter is to be used in conjunction with an external CT of known type then, for enhanced accuracy, the correction apparatus may be adapted to correct for phase and/or ratio errors both in the internal CT and in the external CT.

Further features and advantages of the present invention will become clear from the following description of an embodiment thereof, given by way of example, and illustrated by the accompanying drawings, in which:

Fig. 1 is a graph of the phase difference (in minutes of arc) between the primary current and secondary current, and of the ratio error (as a percentage), in a first and second configuration of current transformer, plotted against the magnitude of the primary current (in Amperes) on a logarithmic scale;

Fig. 2 illustrates diagrammatically an experimental set-up which may be used for obtaining data for graphs according to Fig. 1;

Fig. 3 is a block diagram showing schematically the elements of an electronic electricity meter according to one embodiment of the invention; Fig. 4 shows phasor diagrams illustrating how phase and ratio errors may be compensated in the meter of Fig. 3, in which:

Fig. 4a illustrates compensation of phase error, and

Fig. 4b illustrates compensation of ratio error; and

Fig.5 compares measured and theoretical values of phase angle error, for a particular GOSS core, with theoretical values calculated according to equation (1) with M = 1/2.

The following description relates to an embodiment of the invention wherein phase errors and ratio errors arising in a current metering current transformer which is internal to an electronic electricity meter are substantially compensated within the meter itself. It is to be understood that similar techniques may be applied additionally or alternatively within an electronic electricity meter to compensate for one or both types of such errors arising when an external current transformer is used with such a meter or with a meter lacking an internal current transformer.

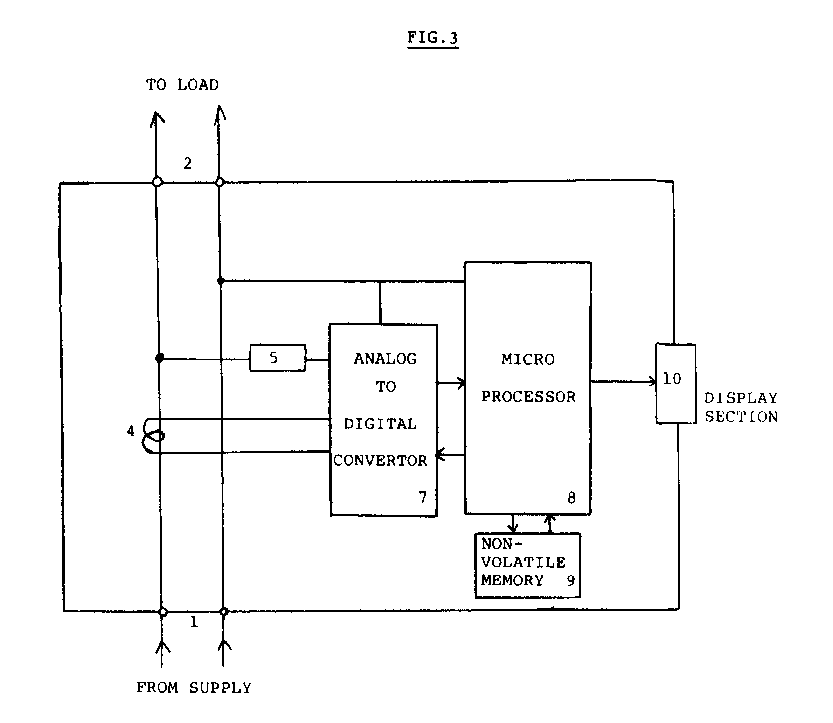

Modern electronic electricity meters incorporating a current transformer also often include a microprocessor, or the like, for calculating energy consumption based on the metered values of load current and supply voltage. The following discussion of compensation for phase and ratio errors assumes that the meter under discussion includes a microprocessor. The elements of such a meter are illustrated in Fig. 3.

The discussion below deals with compensation for phase and ratio errors in respect of a current associated with a single phase of metered supply voltage, the extension of the technique to multiphase supplies is straightforward. When applying the present invention to the metering of multiphase supplies each measured secondary current should be adjusted independently of the other phases (ie. separate calculations of phase and ratio error should be made for each phase's measured secondary current). However, in general it will be permissible to apply equations 1 and 2 in the same form for all of the calculations for that supply (ie. it will usually be appropriate to assume that the current transformers used for the different phases follow the same error equations). It is also assumed that the microprocessor in this embodiment uses a vector representation of the metered quantities in calculation of true power, power factor etc.

Furthermore, in the following embodiment energy consumption is metered by sensing the fundamental frequency component of current, $I'$, at phase $ø'$ relative to voltage, and correcting $I' \cos ø'$ to $I \cos ø$. It has been found that where it is desired to meter total harmonic energy in such an embodiment then a good accuracy is obtained by treating the ratio of true total harmonic energy to measured total harmonic energy as being equal to the ratio of $I \cos ø$ to $I' \cos ø'$. That is, total harmonic energy may be found by scaling the measured/calculated value of total harmonic energy based on the level of correction applied to the fundamental current component.

As shown in Fig. 3 the meter of this embodiment is adapted for connection between the supply and a load (or loads) via input terminals 1 and output terminals 2. A current transformer 4 internal to the meter is used to sense the load current to be measured. The supply voltage to be measured is sensed through a resistor 5. The outputs from the current transformer 4 and resistor 5 are fed to a microprocessor 8 through an analog-to-digital converter 7. The microprocessor 8 is connected to a non-volatile memory 9 which is adapted to store values of the constant $K_1$, $K_2$, $K_3$, $K_4$ and M of equations 1 and 2 above appropriate to the configuration of current transformer used in the meter (e.g. for the core materials, number of turns in the secondary winding etc).

The microprocessor is configured to implement equations (1) and (2) in an appropriate form (ie to apply equation (1) using the stored value of the power, M) and using the stored values of the constants $K_1$ - $K_4$.

The microprocessor 8 is also connected to a display section 10 on which the metered quantities may be displayed. Manual selection means may also be provided to enable a user to select between a number of different metered quantities for display. Additional circuitry may be provided, for example a communications section to enable remote reporting of the metered quantities to take place.

The operation of the meter of Fig. 3 will now be described. Under the control of the microprocessor 8 samples of load current and supply voltage are taken at known times in relation to the fundamental frequency component of either the load current or supply voltage. Before calculating quantities to be output such as real power, total power, reactive power etc the microprocessor 8 adjusts the measured value of current in order to compensate for the effect of phase errors and ratio errors in the current transformer. In order to do this the microprocessor performs a calculation using the initial uncorrected measure of current together with reference to the constants held in the non-volatile memory 9 using equations (1) and (2). An initial measure, or "assumed value", of primary current is produced using the theoretical relationship between primary and secondary current, as follows:

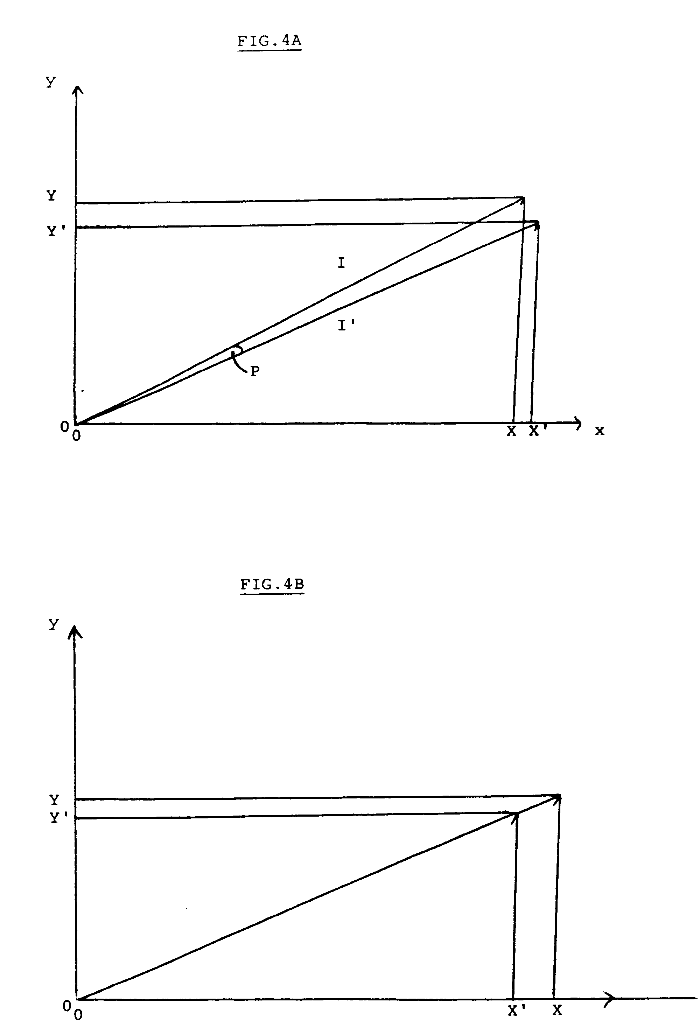

Estimated value of $I_1$ = n x measured value of $I_2$ where n is the turns ratio. This "assumed value" of primary current is then used by the microprocessor to implement equations (1) and (2). The initial measure of primary current is then altered to compensate for phase and/or ratio errors as described below with reference to Figs. 4a and 4b.

As mentioned above, microprocessor 8 of the meter shown in Fig. 3 uses an internal representation of the measured current as a two-component vector. The measured current is represented in Fig. 4a by the vector $I'$ having components $(X', Y')$. In order to compensate for phase error in the current transformer the microprocessor 8 calculates the phase error P using an appropriate form of equation 1 (ie an appropriate power, M) and the values of constants $K_1$ and $K_2$ held in the non-volatile memory 9, and "rotates " the measured current vector $I'$ to produce a corrected current vector I having components $(X, Y)$, as follows:

$$X = X'. \cos(P) - Y'. \sin(P) \quad (4a)$$
$$Y = X'. \sin(P) + Y'. \cos(P) \quad (4b)$$

In practice, since P is small (typically less than 1°) cos (P) approximates to 1, and sin (P) approximates to P so the microprocessor 8 may use simplified equations, as follows:

$$X = X' - Y'. P \quad (5a)$$
$$Y = Y' + X'. P \quad (5b)$$

The microprocessor 8 compensates for ratio error by increasing the magnitude of the measured current vector I' (via calculating the ratio error, re, using the values of the constants $K_3$ and $K_4$ held in non-volatile memory 9 according to equation 2) as follows:

$$X = (1 + re/100) X' \quad (6a)$$
$$Y = (1 + re/100) Y' \quad (6b)$$

The corrected current vector is used by microprocessor 8 in the calculation of the metered quantities.

If it is desired to measure the total harmonic energy then the component of the corrected current vector in phase with the voltage is compared with the uncorrected component and the ratio is used as a correction to the total energy (i.e. it is used as a ratio of "measured energy", ie. energy calculated based on the sensed values of voltage and current, to total energy).

For some metering applications a sufficient increase in metering accuracy may be obtained by compensating only for phase error in the current transformer.

The detailed embodiment described above assumes that the variations in phase error and ratio error, with primary current magnitude, follow equations 1 and 2 exactly (with an appropriate choice of the power, M, in equation 1). In practice, although there is a good fit of measured values to theoretical values (as may be seen from Fig.5 which compares measured values of phase error, obtained for a GOSS core, with theoretical values obtained using power M = 1/2 in equation 1) even greater accuracy may be obtained by storing, in the correction apparatus, information on values of ratio error and/or phase error measured for that particular CT configuration at particular primary current reference points.

The correction circuitry would use the stored values of ratio error and/or phase error when correcting a measured secondary current vector corresponding to one of the reference points. For secondary currents which do not correspond to reference points, equations 1 and 2 would be used, along with stored values of the relevant constants, to produce values for phase and ratio errors by interpolation between, or extrapolation from, the values for the reference points.

In an alternative embodiment of the invention, the correction circuitry could work entirely on stored values of phase and ratio error (at primary current reference joints spaced very close together).

## Claims

1. Electronic electricity meter, comprising:
   means (8) for evaluating the electrical energy consumed by a load, the evaluating means being adapted to evaluate the energy consumption from a signal indicative of voltage supplied to the load and a signal indicative of load current, said load current signal being produced by a current transformer (4);
   characterised in that the meter further comprises storing means (9) storing one or more parameters indicative of the variation with primary current of the phase error or ratio error arising in the secondary current of a current transformer of a predetermined configuration, and the evaluating means is further adapted to process the load current signal so s to produce an adjusted value for the load current signal, said processing making use of said stored parameters.

2. Electronic electricity meter according to claim 1, wherein the one or more parameters stored by the storing means (9) comprise a plurality of values of phase error and/or ratio error for a respective plurality of primary current values of the current transformer of predetermined configuration, and the evaluating means is adapted to process the load current signal so as to produce an estimate of primary current in the current transformer, to select from the storing means (9) a value of phase error and/or ratio error for one of said plurality of primary current values corresponding to the estimated value of primary current and to adjust the load current signal using the selected value of phase and/or ratio error.

3. Electronic electricity meter according to claim 2, wherein the evaluating means is adapted such that if the estimated primary current value does not correspond to one of said plurality of primary current values then the evaluating means calculates a value of phase error, for use in producing the adjusted value of load current signal, based on the following equation:

   $$P = K_1 + K_2.I_1^{-M}$$

   where P is the calculated value of phase error, $K_1$, $K_2$ and M are constants relating to the configuration of the current transformer of predetermined configuration, and $I_1$ is the estimated primary current of the current transformer.

4. Electronic electricity meter according to claim 2 or 3, wherein the evaluating means is adapted such that if the estimated primary current value does not correspond to one of said plurality of primary current values then the evaluating means calculates a value of ratio error for use in producing the adjusted value of load current signal based on the following equation:

$$RE = K_3 + K_4.\log I_1$$

where RE is the calculated value for the ratio error (expressed as a percentage), $K_3$ and $K_4$ are the constants relating to the configuration of the current transformer of -predetermined configuration, and $I_1$ is the estimated primary current of the transformer.

5. Electronic electricity meter according to claim 1, wherein the evaluating means is adapted to calculate a value for phase error for use in producing the adjusted value of load current signal, based on the following equation:

$$P = K_1 + K_2.I_1^{-M}$$

where P is the calculated value of phase error, $K_1$, $K_2$ and M are constants relating to the configuration of the current transformer of predetermined configuration, and $I_1$ is primary current of the current transformer.

6. Electronic electricity meter according to claim 1 or 5, wherein the evaluating means is adapted to calculate a value for ratio error, for use in producing the adjusted value of load current signal, based on the following equation:

$$RE = K_3 + K_4.\log I_1$$

where RE is the calculated value of ratio error (expressed as a percentage), $K_3$ and $K_4$ are constants related to the configuration of the current transformer of predetermined configuration, and $I_1$ is the primary current of the current transformer.

7. Electronic electricity meter according to any one of claims 1 to 6, and further comprising an internal current transformer, wherein the load current signal from which the evaluating means evaluates energy consumption is produced by said internal current transformer.

8. Electronic electricity meter according to any one of claims 1 to 7, wherein the load current signal from which the evaluating means evaluates the energy consumption is produced from an external current transformer.

FIG. 1

CURRENT TRANSFORMER PERFORMANCE

— 4 primary turns; 1000 secondary turns
— — 16 primary turns; 4,000 secondary turns

FIG.2

$V_2(t) \propto I_2(t)$

40 $\Omega$

4000 turns

16 turns

0.2 $\Omega$

$V_1(t) \propto I_1(t)$

10 $\Omega$

V(t)

50 Hz Supply

FIG.3

FIG.4A

FIG.4B

FIG.5

EP 0 466 453 A2